# EUROPEAN PATENT SPECIFICATION

(11) **EP 0 564 660 B1**
(45) Date of publication and mention of the grant of the patent: **28.01.1998**
(21) Application number: 92922491.3
(22) Date of filing: 26.10.1992
(51) Int. Cl.: H01L 21/68, C08J 5/04, C08L 71/12

(54) **TRAY FOR INTEGRATED CIRCUITS**
KASTEN FÜR INTEGRIERTE SCHALTUNGEN
BAC POUR CIRCUITS INTEGRES

(30) Priority: 25.10.1991 JP 279558/91
(43) Date of publication of application: 13.10.1993
(73) Proprietor: MITSUI TOATSU CHEMICALS, Inc., Chiyoda-Ku Tokyo 100 (JP)
(72) Inventor: UEKI, Toru 16-1, Kitashin, Kanagawa 246 (JP); YOSHIMURA, Masaji, Yokohama-shi Kanagawa 244 (JP); KANEZAKI, Kazuharu 2070, Iijimacho, Yokohama-shi Kanagawa 244 (JP); IWATA, Ineo 3-42-7-144, Hirado, Yokohama-shi Kanagawa 244 (JP); TAKIGUCHI, Minoru 4-5-45, Dai, Kanagawa 247 (JP)
(74) Representative: Luderschmidt, Schüler & Partner GbR
(86) International application number: JP9201385
(87) International publication number: WO9308595

(56) References cited:
- WO-A-90/14386
- JP-A-57 007 922
- JP-A-61 259 981
- US-A- 4 404 125
- DATABASE WPI Derwent Publications Ltd., London, GB; AN 92-045779(06) & JP-A-3 290 463
- DATABASE WPI Derwent Publications Ltd., London, GB; AN 86-243491(37) & JP-A-61 174 262
- DATABASE WPI Derwent Publications Ltd., London, GB; AN 90-101982(14) & JP-A-2 051 237

## Description

### Technical Field

The present invention relates to a tray for IC which is excellent in electrical conductivity and toughness and which is free from warpage.

### Background Art

With the high mounting of electronic equipments, IC parts are mounted on through-hole substrates and the like in order to further increase a mounting density thereof. However, if the IC parts containing moisture are mounted with a flow solder, water vapor is generated in the IC parts during heating, so that swelling or cracks take place to damage the IC parts. Prior to the mounting, therefore, it is necessary that the IC parts are dried at a temperature of 100°C or more to remove the moisture therefrom.

In a conventional IC drying process, the IC parts are transferred from a tray made of a conductive vinyl chloride or polystyrene resin to an aluminum die casting tray, and after the drying, they are returned to the resin tray again and then shipped, which drying process is complex. Thus, in place of the expensive aluminum die casting tray, the utilization of a plastic tray made of a polyphenylene ether resin composition which can withstand 100°C or more has been investigated for the simplification of the drying process.

Such a plastic tray is made of a material in which electrically conductive carbon is kneaded with the polyphenylene ether resin. When the plastic trays are carried, they are brought into contact with each other or into contact with the parts sometime and they are often rubbed at this time, so that conductive carbon which is a filler constituting the surface of the tray peels off and then adheres to IC lead wires at times. In consequence, in soldering the IC parts on an electronic circuit, a fusing failure occurs between the lead wires and a solder owing to the adhered carbon, with the result that a sufficient electrical connection cannot be obtained between the electronic circuit and the IC parts sometimes.

In order to solve such a problem, there has been contrived a technique in which the tray for IC is obtained by using a carbon fiber instead of conductive carbon. U.S. Patent No. 4404125 discloses a technique in which the carbon fiber is applied to a polyphenylene ether resin. However, the object of this technique is electro-magnetic wave shielding, and for the purpose of the electro-magnetic wave shielding, a volume resistivity of 10⁻¹ Ω or less is necessary, which is noticeably different from properties required for the tray for IC of the present invention. That is, it is necessary that the conductivity of the tray for IC is controlled so as to be in the range of from 10¹ to 10¹² Ω in terms of surface resistivity, or in the range of from 10¹ to 10¹² Ωcm in terms of volume resistivity. When the tray for IC is directly brought into contact with the lead wires of the IC parts, a short occurs between the leads wires of the IC parts to damage the IC at times, provided that the surface resistivity of the tray is less than 10¹ Ω. Also in the case that the surface resistivity is more than 10¹² Ω, static electricity is generated, so that the IC is similarly damaged at times.

The carbon fiber which has heretofore been used has a fiber length of 3 mm or more, and as a reinforcement filler or for the purpose of the electro-magnetic wave shielding, the carbon fiber has been added to a resin. However, in the case that an injection molding method is employed, the carbon fiber is oriented in a specific direction in molded articles, and as a result, molding shrinkage takes place under an anisotropic state, which gives rise to warpage. In particular, since the tray for IC has a small wall thickness and a plane structure, the large warpage which is a serious problem occurs. That is, the tray for IC is handled in an automatic machine, and therefore, for example, when the 300 mm × 150 mm tray for IC is put on a plate, a relief from the bottom of the tray must be 1 mm or less. This problem and other problems are still present in the conventional techniques.

### Disclosure of the Invention

The present invention intends to solve the above-mentioned problems of a tray for IC and specifically, it intends to provide a heat-resistant tray for IC which has a suitable resistivity and which is free from warpage and is excellent in toughness.

The present inventors have intensively investigated to solve the above-mentioned problems, and as a result, they have found a composition which comprises a selected polyphenylene ether resin, a carbon fiber and a lamellar inorganic filler and which can sufficiently achieve the above-mentioned purpose as the tray for IC. In consequence, the present invention has now been attained.

That is, the present invention provides a heat-resistant tray for IC which is obtained by molding a thermoplastic resin composition formed by kneading (A) 100 parts by weight of a polyphenylene ether resin, (B) 0.1 to 40 parts by weight of a carbon fiber having a number-average fiber length in the range of from 0.05 to 1.5 mm, and (C) 0.1 to 50 parts by weight of a lamellar inorganic filler having an aspect ratio of 20 or more, the surface resistivity of the tray being in the range of from 10¹ to 10¹² Ω.

### Best Mode for Carrying out the Invention

A polyphenylene ether resin of a component (A) which is used in the present invention is a polyphenylene ether resin having one or more kinds of units represented by the formula 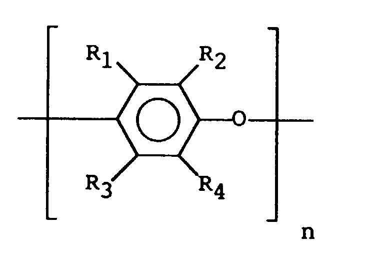 wherein each of R₁, R₂, R₃ and R₄ is independently selected from the group consisting of a hydrogen atom, a halogen atom, a hydrocarbon group, a halohydrocarbon group, a hydrocarbonoxy group and a halohydrocarbonoxy group; and n is the total number of monomer units and it is an integer of 20 or more. Preferably a mixture of a styrene resin and the polyphenylene resin is used.

No particular restriction is put on a preparation method of the polyphenylene ether resin, but it can be prepared by any one of methods described in U.S. Patent Nos. 3306874, 3306875, 3257357 and 3257358. In the present invention, a poly(2,6-dimethyl-1,4-phenylene) ether can also be most preferably used.

Examples of the styrene resin which is used herein include homopolymers and copolymers of styrene derivative monomers which are α-substituted styrenes such as styrene monomer and methylstyrene, and nucleus-substituted styrenes such as p-t-butylstyrene, p-methylstyrene, vinyltoluene and chlorostyrene, copolymers of one or more of these styrene monomers and another monomer, for example, a styrene-acrylonitrile copolymer (an AS resin), a graft polymer obtained by graft-polymerizing one or more of these styrene monomers or the same and another monomer on a polybutadiene rubber, for example, a styrene graft polymer (an HIPS resin) and a styrene-acrylonitrile graft polymer (an ABS resin). These styrene resins can be manufactured in accordance with a well-known procedure by a person skilled in the art, and they are commercially available.

Furthermore, a carbon fiber of a component (B) is also essential to obtain a tray for IC, and the conformation and the amount of the carbon fiber are important to control the conductivity and the surface resistivity of the tray so as to be in suitable ranges. Examples of the carbon fiber which can be used in the present invention include all of usual known carbon fibers, for example, carbon fibers manufactured by calcining fibers such as cellulose and polyacrylonitrile, carbon fibers manufactured by melting and spinning petroleum or coal pitch. Typical commercial examples of the carbon fiber include Xylus (trade name, made by Nitto Boseki Co., Ltd.) and Dialead (trade name, made by Mitsubishi Chemical Industries, Ltd.) which mainly comprise pitch, and Kurekachop (trade name, made by Kureha Chemical Industry Co., Ltd.) which mainly comprises the polyacrylonitrile fiber.

The carbon fiber is a fibrous bundle of many single fibers having a diameter of from 5 to 15 µm, and in particular, it is important that the number average fiber length of the carbon fiber is in the range of from 0.05 to 1.5 mm. When the number average fiber length is less than 0.05 mm, the surface resistivity of the tray obtained therefrom cannot be controlled so as to be in the suitable range of the present invention, i.e., in the range of from 10¹ to 10¹² Ω. This is considered to be for the following reason: the fiber length is too short, and the fibers do not twine round each other in the molded article, so that conductive passages are not connected to each other and so it is difficult to impart the conductivity to the molded article. When the number average fiber length is more than 1.5 mm, warpage occurs even if a lamellar inorganic filler which is a component (C) is added. Eventually, such a carbon fiber cannot be used as a material of the tray for IC. Furthermore, the amount of the carbon fiber to be added is in the range of from 0.1 to 40 parts by weight, preferably from 10 to 30 parts by weight. When the amount of the carbon fiber is less than 0.1 part by weight, the conductivity is 10¹² Ω or more, and when it is in excess of 40 parts by weight, the conductivity is less than 10¹ Ω, which is unpreferably outside the proper range of the present invention. If the conductivity is less than 10¹ Ω, a short occurs unpreferably between the leads wires of the IC parts to damage the IC at times.

The lamellar inorganic filler having an aspect ratio of 20 or more which is the component (C) is mica or talc, and they have a lamellar shape and an aspect ratio of 20 or more. The aspect ratio in the present invention can be defined as L/t wherein "L" is an average diameter of the surface of the lamellar filler and "t" is an average thickness of the lamellar filler, and in the present invention, the lamellar inorganic filler in which L/t is 20 or more can be used. In the present invention, mica and talc which mainly comprise a silicate are used. The employment of such a lamellar inorganic filler is particularly effective for the inhibition of the warpage among characteristics of the molded tray for IC. The warpagefree tray for IC cannot be obtained by using the carbon fiber alone, and only when the carbon fiber and the lamellar inorganic filler are simultaneously used, the tray for IC of the present invention can be obtained. When the aspect ratio of the filler is less than 20, it is difficult to inhibit the warpage to 1 mm or less, even if the filler is a lamellar silicate. Furthermore, the amount of the lamellar inorganic filler is in the range of from 0.1 to 50 parts by weight, preferably from 10 to 40 parts by weight. When the amount of the lamellar inorganic filler is less than 0.1 part by weight, it is difficult to inhibit the warpage to 1 mm or less. When it is more than 50 parts by weight, the toughness of the tray deteriorates, and thus such an excessive amount is not practical.

As is apparent from the foregoing, the amounts of the respective components which can be used in the present invention are as follows: the amount of the carbon fiber (B) having a number-average fiber length in the range of from 0.05 to 1.5 mm is from 0.1 to 40 parts by weight, and that of the lamellar inorganic filler (C) is from 0.1 to 50 parts by weight with respect to 100 parts by weight of the polyphenylene ether resin (A).

The composition of the three components (A), (B) and (C) can be prepared by a usual known method. That is, the three components (A), (B) and (C) are uniformly mixed, and the mixture is then melted and kneaded by a uniaxial or a multi-axial extruder having a sufficient kneading power. Afterward, the kneaded material is molded into a desired tray for IC by an injection molding method or a press molding method which is a usual molding method. If necessary, optional additives can be added to the above-mentioned composition, and examples of the additives include a pigment, a dye, a reinforcement material such as a glass fiber, an impact strength modifier such as a conjugated diene block copolymer, a high fluidization agent such as a low-molecular weight polystyrene, a low-molecular weight styrene-alkyl maleate ester copolymer or a low-molecular weight styrene-maleimide copolymer, an antioxidant, an ultraviolet absorber, an aggregate and a flameretardant.

Moreover, the above-mentioned composition can be suitably utilized as a TAB carrier, a rack and a magazine case in addition to the tray for IC.

### <Examples>

The present invention will be described in detail in reference to examples, but the scope of the present invention should not be limited to these examples. Incidentally, characteristics of resin compositions and molded articles mentioned in the examples and comparative examples were evaluated by the following procedures.

### (1) Warpage of molded articles (trays for ICs)

A 300 mm × 150 mm tray was allowed to stand in a drying machine at 150°C for 24 hours, and it was then put on a plate. Next, 9 points on the periphery of the tray were selected at uniform intervals as measurement points, and a height at each point of the tray from the plate surface was measured. A difference of the height between a maximum value and a minimum value was evaluated as a warpage value.

### (2) Conductivity of tray

A surface resistivity of the tray article was measured at an application voltage of 100 V for an application time of 10 seconds by a surface high-resistance meter (trade name Hirestor) made by Mitsubishi Petrochemical Co., Ltd.

### (3) Toughness of tray

The tray was allowed to spontaneously fall on a concrete surface from a height of 2 m, and the presence of breakage was then observed.

### Example 1

15 parts by weight of a pitch-based carbon fiber [trade name XYLUS, made by Nitto Boseki Co., Ltd., fiber diameter = 13 µm, average fiber length = 0.3 mm] and 10 parts by weight of mica flakes [trade mark S-100, made by Canada Mica Co., Ltd., aspect ratio = 65] as a lamellar inorganic filler were blended with 100 parts by weight of a polyphenylene ether resin (PPE) [made by GEM Polymer Co., Ltd.] as a thermoplastic resin composition, and the mixture was then extruded at 300°C by the use of a twin-screw extruder of 35 mm to form pellets. Next, a tray article having a size of 300 mm × 150 mm was molded from these pellets at a molding temperature of 300°C at a mold temperature of 100°C by the use of an injection molding machine made by The Japan Steel Works, Ltd., and the above-mentioned characteristics were then measured. The results are set forth in Table 1. The warpage, conductivity and toughness of the tray were all so good as to be sufficiently practical.

### Examples 2 to 6

The same procedure as in Example 1 was repeated except that the amount and fiber length of a carbon fiber as well as the amount of a lamellar inorganic filler were changed as shown in Table 1. The results are set forth in Table 1. The warpage, conductivity and toughness of the trays were all so good as to be sufficiently practical.

### Comparative Examples 1 to 6

The same procedure as in Example 1 was repeated except that the amount and fiber length of a carbon fiber as well as the amount of an inorganic filler were changed as shown in Table 2. The results are set forth in Table 2. Any of the warpage, conductivity and toughness of the trays were so poor as to be impractical.

### Example 7

The same procedure as in Example 1 was repeated except that 100 parts by weight of polyphenylene ether resins, i.e., 50 parts by weight of a polyphenylene ether resin (made by GEM Polymer Co. Ltd.) and 50 parts by weight of a rubber-modified styrene graft copolymer (trade name Topolex 855-51, made by Mitsui Toatsu Chemicals, Inc.) were used. The results are set forth in Table 1. The warpage, conductivity and toughness of the tray were all so good as to be sufficiently practical.

**Table 1**

| | **Example** | | | | | | |
|---|---|---|---|---|---|---|---|
| | 1 | 2 | 3 | 4 | 5 | 6 | 7 |
| Polyphenylene Ether Resin | PPE | ← | ← | ← | ← | ← | PPO/HIPS |
| Amount (pts. wt.) | 100 | ← | ← | ← | ← | ← | 50/50 |
| Carbon Fiber Fiber Length (mm) | 0.3 | ← | ← | ← | ← | 0.1 | 0.3 |
| Amount (pts. wt.) | 15 | 5 | 30 | 15 | ← | ← | ← |
| Lamellar Inorganic Filler | 200-HK | ← | ← | ← | ← | ← | ← |
| Amount (pts. wt.) | 20 | ← | ← | 5 | 40 | 20 | ← |
| Warpage·Deformation (mm) | 0.2 | 0.1 | 0.2 | 0.2 | 0.1 | 0.2 | 0.2 |
| Surface Resistivity (Ω) | 10⁵ | 10⁶ | 10⁴ | 10⁵ | 10⁵ | 10⁷ | 10⁵ |
| Tray Toughness | Good | Good | Good | Good | Good | Good | Good |

**Table 2**

| | **Comparative Example** | | | | | |
|---|---|---|---|---|---|---|
| | 1 | 2 | 3 | 4 | 5 | 6 |
| Polyphenylene Ether Resin | PPE | ← | ← | ← | ← | ← |
| Amount (pts. wt.) | 100 | ← | ← | ← | ← | ← |
| Carbon Fiber Fiber Length (mm) | 0.3 | ← | ← | ← | 0.01 | 3 |
| Amount (pts. wt.) | 50 | 0 | 15 | ← | ← | ← |
| Lamellar Inorganic Filler | 200-HK | ← | ← | 200-HK | ← | ← |
| Amount (pts. wt.) | 20 | ← | 0 | 60 | 20 | ← |
| Warpage·Deformation (mm) | 0.3 | 0.1 | 6.3 | 0.2 | 0.1 | 5.5 |
| Surface Resistivity (Ω) | 10⁻¹ | >10¹² | 10⁵ | 10⁹ | >10¹² | 10⁵ |
| Tray Toughness | Good | Good | Good | Damaged | Good | Good |

### Example 8

15 parts by weight of a pitch-based carbon fiber [trade name XYLUS, made by Nitto Boseki Co., Ltd., fiber diameter = 13 µm, average fiber length = 0.3 mm] and 10 parts by weight of mica flakes [trademark S-100, made by Canada Mica Co., Ltd., aspect ratio = 65] as a lamellar inorganic filler were mixed with 100 parts by weight of polyphenylene ether resins, i.e., 80 parts by weight of a polyphenylene ether resin (PPE) (made by GEM Polymer Co. Ltd.) and 20 parts by weight of a polystyrene resin (PS) (trade name Topolex 550-51, made by Mitsui Toatsu Chemicals, Inc.), and the mixture was then extruded at 300°C by the use of a twin-screw extruder of 35 mm to form pellets. Next, a tray article having a size of 300 mm x 150 mm was molded from these pellets at a molding temperature of 300°C at a mold temperature of 100°C by the use of an injection molding machine made by The Japan Steel Works, Ltd., and the above-mentioned characteristics were then measured. The results are set forth in Table 3. The warpage, conductivity and toughness of the tray were all so good as to be sufficiently practical.

### Examples 9 to 16

The same procedure as in Example 8 was repeated except that the amount and fiber length of a carbon fiber as well as the amount of a lamellar inorganic filler were changed as shown in Table 3. The results are set forth in Table 3. The warpage, conductivity and toughness of the trays were all so good as to be sufficiently practical.

### Example 17

The same procedure as in Example 8 was repeated except that mica flakes having an aspect ratio of 28 [trademark S-500, made by Canada Mica Co., Ltd.] were used. The results are set forth in Table 3. The warpage, conductivity and toughness of the tray were all so good as to be sufficiently practical.

### Example 18

The same procedure as in Example 8 was repeated except that talc having an aspect ratio of 30 was used. The results are set forth in Table 3. The warpage, conductivity and toughness of the tray were all so good as to be sufficiently practical.

### Comparative Examples 7 to 14

The same procedure as in Example 8 was repeated except that the amount and number-average fiber length of a carbon fiber as well as the amount and aspect ratio of an inorganic filler were changed as shown in Table 4. The results are set forth in Table 4. Any of the warpage, conductivity and toughness of the trays were so poor as to be impractical.

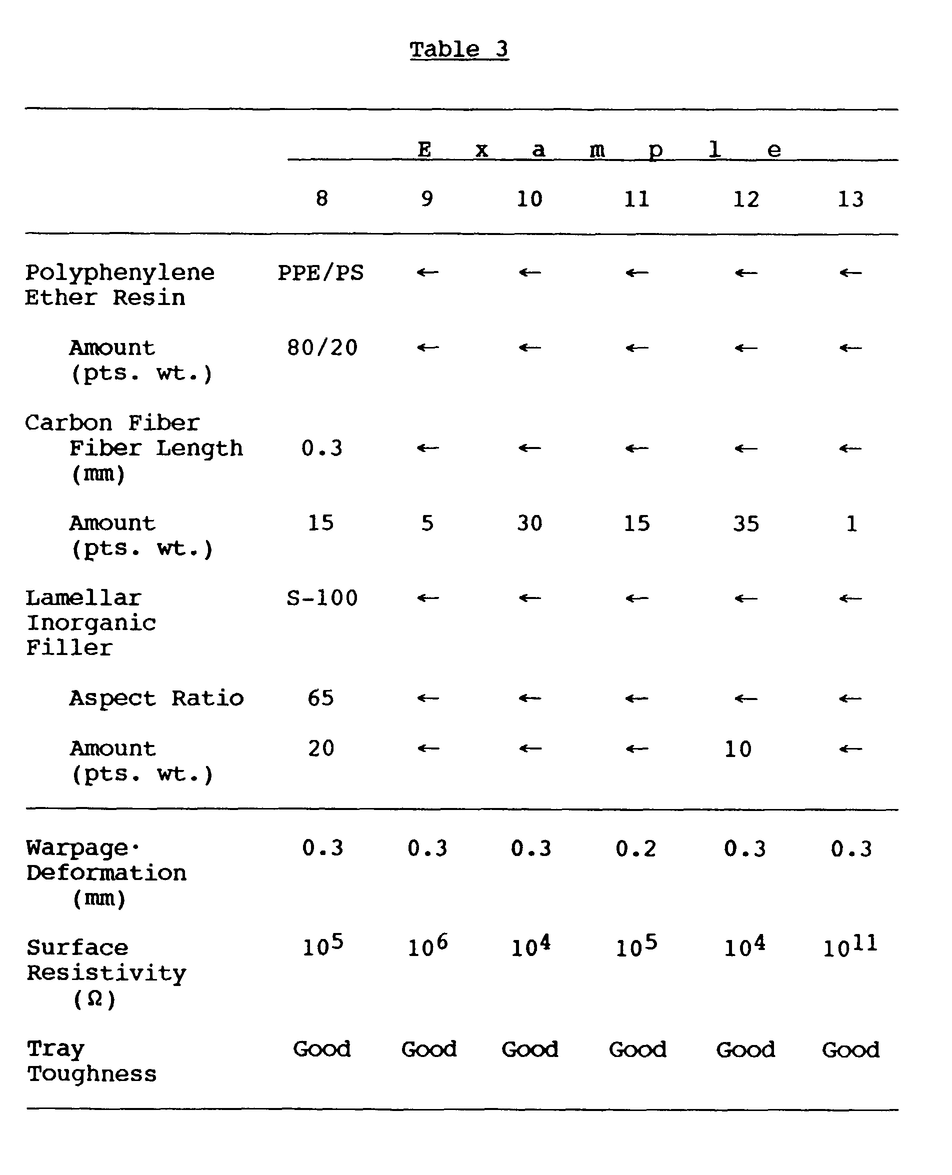

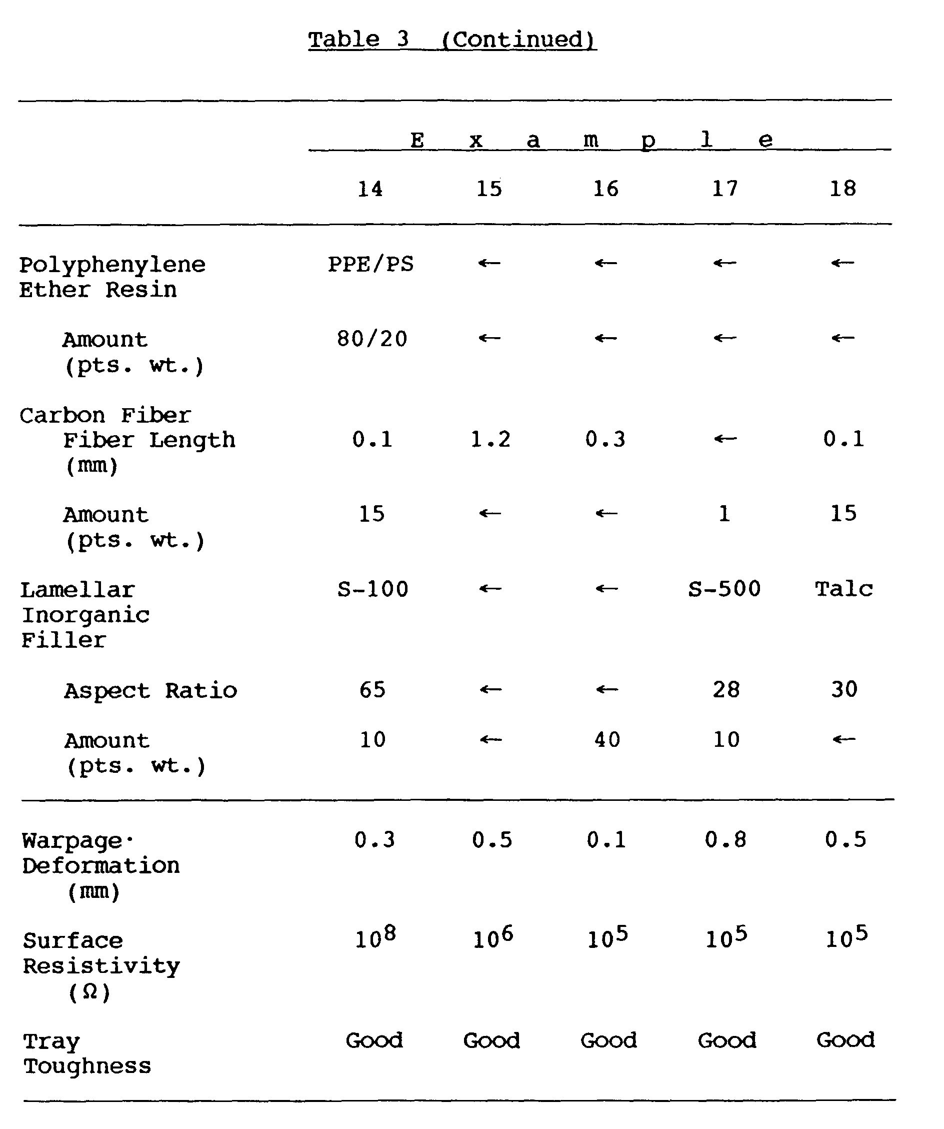

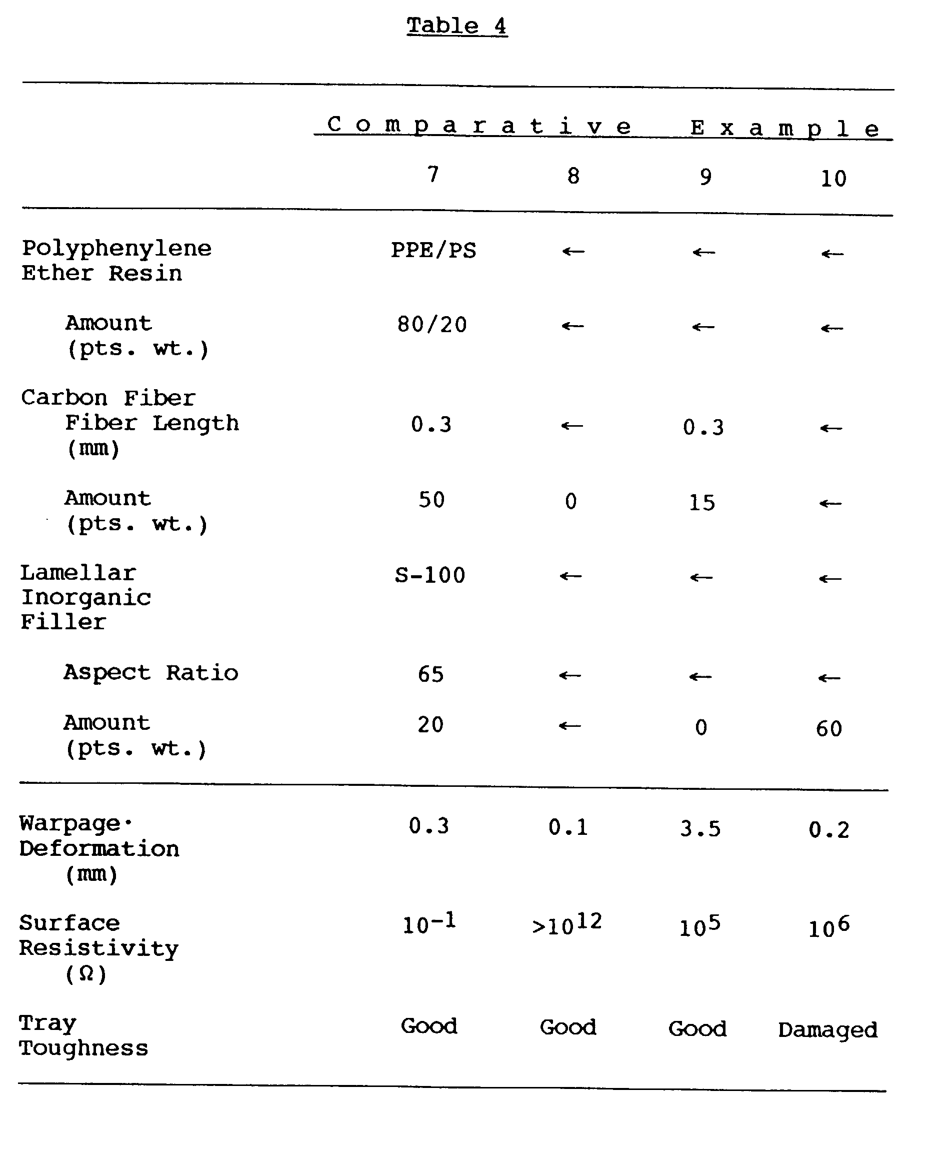

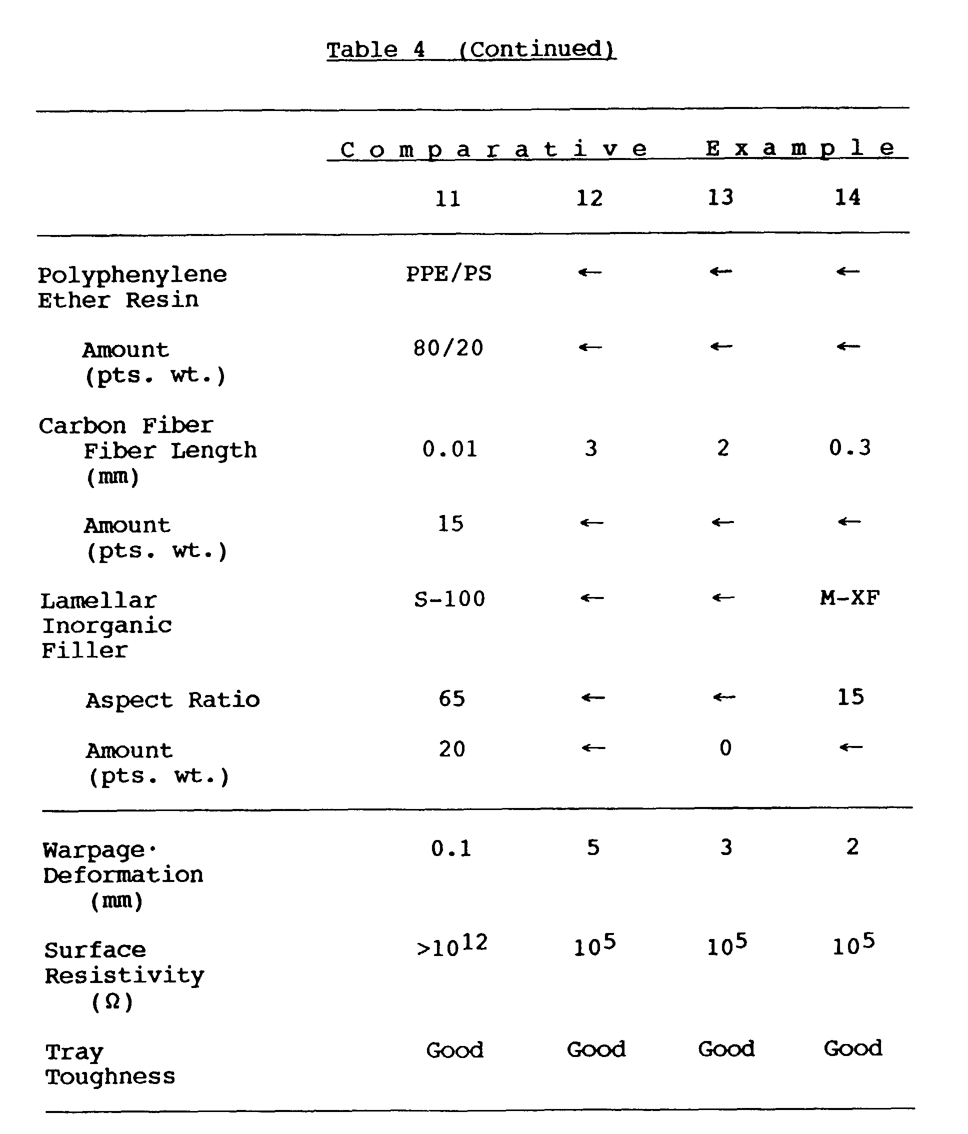

## Claims

1. A tray for IC'S which is obtained by molding a thermoplastic resin composition formed by kneading materials which comprises (A) 100 parts by weight of a polyphenylene ether resin comprising one or more kinds of units represented by the formula 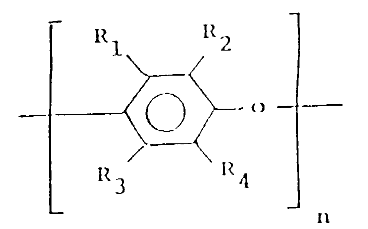 wherein each of R₁, R₂, R₃ and R₄ is independently selected from the group consisting of a hydrogen atom, a halogen atom, a hydrocarbon group, a halohydrocarbon group, a hydrocarbonoxy group and a halohydrocarbonoxy group; and n is the total number of monomer units and is an integer of 20 or more, (B) 0,1 to 40 parts by weight of a carbon fiber having a number-average fiber length in the range from 0,05 to 1,5 mm and a diameter of from 5 to 15 µm, and (C) 0,1 to 50 parts by weight of a lamellar inorganic filler having an aspect ratio of 20 or more selected from the group consisting of mica and talc, the surface resistivity of said tray being in the range of from 10¹ to 10¹² Ω and the warpage of said tray being 1 mm or less when measured in accordance with the following procedure:
(a) drying a 300 x 150 mm tray at 150°C for 24 hours,
(b) placing said tray on a plate, and
(c) selecting nine (9) measurement points at uniform intervals around the tray periphery and measuring, at each point, the height of the tray periphery from the plate surface.

2. The tray for IC according to Claim 1 wherein the polyphenylene resin is a mixture including a styrene resin, said styrene resin being a homopolymer or a copolymer of a styrene derivative monomer which is an α-substituted styrene such as a styrene monomer or methylstyrene, or a nucleus-substituted styrene such as p-t-butylstyrene, p-methylstyrene, vinyltoluene or chlorostyrene, or a copolymer of one or more of these styrene monomers and another monomer.

3. The tray for IC according to Claim2 wherein said copolymer of one or more of the styrene monomers and another monomer is a styrene-acrylonitrile copolymer, or a graft polymer obtained by graft-polymerizing one or more of the styrene monomers or the same and another monomer on a polybutadiene rubber.

4. The tray for IC according to Claim 1 wherein the amount of said carbon fiber to be added is in the range of from 10 to 30 parts by weight.

5. The tray for IC according to Claim 1 wherein the amount of said lamellar inorganic filler to be added is in the range of from 10 to 40 parts by weight.

## Patentansprüche

1. Kasten für integrierte Schaltungen, der durch Formen einer aus Knetmasse gebildeten thermoplastischen Harzzusammensetzung erhalten wird, welche enthält:
(A) 100 Gewichtsteile eines Harzes aus Polyphenylenether mit einer oder mehreren Arten der durch die Formel 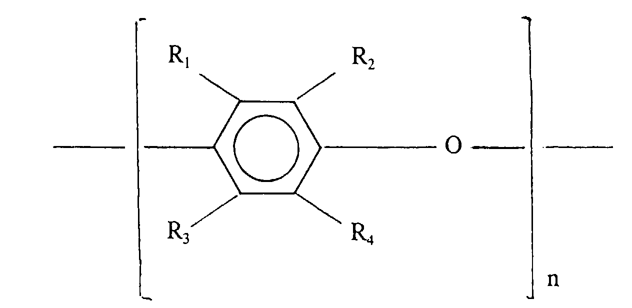 wiedergegebenen Untereinheiten, in welcher R₁, R₂, R₃ und R₄ unabhängig voneinander ausgewählt sind aus der Gruppe Wasserstoffatom, Halogenatom, einer Kohlenwasserstoffgruppe, einer Halogenkohlenwasserstoffgruppe, einer Kohlenwasserstoffoxy-Gruppe und einer Halogenkohlenwasserstoffoxy-Gruppe; und n die Summe der monomeren Untereinheiten sowie eine ganze Zahl von 20 oder darüber ist,
(B) 0,1 bis 40 Gewichtsteile einer Kohlefaser mit einer mittleren Faserlänge (Zahlenmittel) im Bereich von 0,05 bis 1,5 mm und einem Durchmesser von 5 bis 15 µm, und
(C) 0,1 bis 50 Gewichtsteile eines lamellenförmigen organischen Füllstoffs mit einem Seitenverhältnis von 20 oder mehr und ausgewählt aus der Gruppe Glimmer und Talk, wobei der spezifische Oberflächenwiderstand des Kastens im Bereich von 10¹ bis 10¹² Ω liegt und die Verwölbung des Kastens 1 mm oder weniger beträgt, wenn gemäß dem folgenden Verfahren gemessen wird:
(a) Trocknen eines Kastens von 300 x 150 mm bei 150°C über einen Zeitraum von 24 Stunden,
(b) Stellen des Kastens auf eine Platte, und
(c) Auswählen von neun (9) Meßpunkten in gleichen Abständen um die Oberfläche des Kastens und Messen des Höhenabstands eines jeweiligen Punktes an der Oberfläche des Kastens von der Oberfläche der Platte.

2. Kasten für integrierte Schaltungen nach Anspruch 1, in welchem das Polyphenylenharz in Mischung mit einem Styrolharz vorliegt, wobei das Styrolharz ein Homo- oder Copolymer eines monomeren Styrolderivats ist, welches ein α-substituiertes Styrol wie z.B. ein Styrolmonomeres oder Methylstyrol, oder ein kernsubstituiertes Styrol wie z.B. p-t-Butylstyrol, p-Methylstyrol, Vinyltoluol oder Chlorstyrol, oder ein Copolymer eines oder mehrerer dieser Styrolmonomeren und eines anderen Monomers ist.

3. Kasten für integrierte Schaltungen nach Anspruch 2, in welchem das Copolymer eines oder mehrerer dieser Styrolmonomeren und eines anderen Monomers ein Styrol-Acrylnitril-Copolymer ist oder ein Pfropfpolymer, das mittels Pfropfpolymerisation eines oder mehrerer der Styrolmonomeren oder des gleichen und eines anderen Monomers auf einem Gummi aus Polybutadien erhalten wird.

4. Kasten für integrierte Schaltungen nach Anspruch 1, in welchem der Gehalt der zuzusetzenden Kohlefaser im Bereich von 10 bis 30 Gewichtsteilen liegt.

5. Kasten für integrierte Schaltungen nach Anspruch 1, in welchem der Gehalt des zuzusetzenden lamellenförmigen anorganischen Füllstoffs im Bereich von 10 bis 40 Gewichtsteilen liegt.

## Revendications

1. Bac pour des circuits intégrés obtenu par moulage d'une résine thermoplastique formée par matières pétrissables et contenant (A) 100 parties en poids d'une résine d'éthers polyaryliques contenant une ou plusieures sortes d'unités representées par la formule 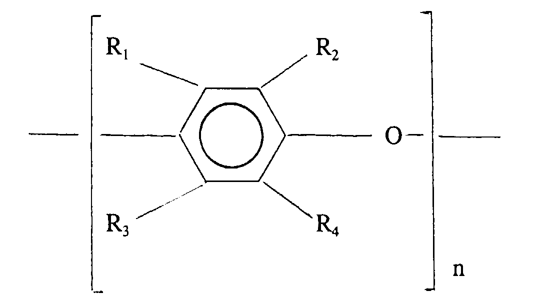 dans laquelle chacun des résidus R1, R2, R3 et R4 est choisi indépendamment dans le groupe constitué par un atome d'hydrogène, un atome d'halogène, un groupe d'hydrocarbure, un groupe d'hydrocarbure halogéné, un groupe d'hydrocarbureoxy et un groupe d'hydrocarbureoxy halogéné; et n représente le total d'unités monomères et est un nombre entier de 20 ou en delà, (B) 0,1 à 40 parties en poids d'une fibre de carbone ayant une valeur moyenne d'un nombre de la longueur de la fibre comprise entre 0,05 et 1,5 mm et un diamètre compris entre 5 et 15 µm, et (C) 0,1 à 50 parties en poids d'une charge lamellaire minérale d'un rapport de hauteur à la largeur de 20 ou en delà et choisie dans le groupe constitué par le mica et la stéatite, la résistence de surface dudit bac étant comprise entre 10¹ et 10¹² Ω et le gauchissement dudit bac étant 1 mm ou moins en cas d'un mesurage d'après la procédure suivante:
(a) faire sécher un bac de 300 x 150 mm à une température de 150°C pendant 24 heures,
(b) mettre ledit bac sur une plaque, et
(c) choisir neuf (9) points de mesurage à intervalles égaux à l'entour de la circonférence du bac et mesurer à chaque point la hauteur de la circonférence du bac à partir de la surface de la plaque.

2. Le bac pour des circuits intégrés d'après la revendication 1, dans lequel la résine polyarylique est un mélange comportant une résine au styrène, ladite résine au styrène étant un homopolymère ou un copolymère du dérivé styrénique monomère qui est un styrène α-substitué tel qu'un monomère styrénique ou le méthylstyrène, ou un styrène substitué au noyau tel que p-t-butylstyrène, p-méthylstyrène, vinyltoluène ou chlorstyrène, ou un copolymère à partir d'un ou plusieurs desdits monomères styréniques et d'un autre monomère.

3. Le bac pour des circuits intégrés d'après la revendication 2, dans lequel ledit copolymère à partir d'un ou plusieurs des monomères styréniques et d'un autre monomère est un copolymère d'acrylnitrile-styrène ou un polymère greffé obtenu par moyen d'une polymérisation par greffage d'un ou plusieurs des monomères styréniques ou du même et un autre monomère sur un caoutchouc de polybutadiènes.

4. Le bac pour des circuits intégrés d'après la revendication 1, dans lequel la quantité de ladite fibre de carbone qu'il faut ajouter se situe dans la gamme de 10 à 30 parties en poids.

5. Le bac pour des circuits intégrés d'après la revendication 1, dans lequel la quantité de ladite charge lamellaire minérale qu'il faut ajouter se situe dans la gamme de 10 à 40 parties en poids.
